Europäisches Patentamt

European Patent Office

Office européen des brevets

(19)

(11) EP 1 037 060 A2

(12) **EUROPEAN PATENT APPLICATION**

(43) Date of publication:
20.09.2000 Bulletin 2000/38

(51) Int Cl.$^7$: **G01R 27/32**

(21) Application number: 00302008.8

(22) Date of filing: 13.03.2000

(84) Designated Contracting States:
**AT BE CH CY DE DK ES FI FR GB GR IE IT LI LU MC NL PT SE**
Designated Extension States:
**AL LT LV MK RO SI**

(30) Priority: **11.03.1999 GB 9905485**

(71) Applicant: **Alenia Marconi Systems Limited**
**Stanmore, Middlesex HA7 4LY (GB)**

(72) Inventors:
• **Lucas, Christopher Richard**
**Botley, Hampshire SO30 2GW (GB)**
• **Bartlam, Phillip Craig**
**Havant, Hampshire PO9 3NJ (GB)**
• **Yates, Mark Jonathon**
**Eastleigh, Hampshire SO53 4LT (GB)**

(74) Representative: **Camp, Ronald**
**Marconi Intellectual Property**
**Waterhouse Lane**
**Chelmsford Essex CM1 2QX (GB)**

(54) **Measuring electromagnetic energy device parameters**

(57) A scalar reflectometer for measuring Insertion Loss and Reflection Loss of a two-port network (40) consists of a symmetrical arrangement of directional couplers (30, 130) each having detectors (13, 14; 113, 114) for measuring incident and reflected power. A change over switch (60) allows RF power from a signal source (10) to be directed to either port (42, 44) of the network according to the switch setting, thereby allowing the losses to be determined in both directions without disturbing the connections to the network. Swept measurements may be taken, the instantaneous frequency being conveyed by a connection path (22) to a unit (20) which evaluates and displays the appropriate parameters being measured. Circulators (12, 112) dispose of unwanted reflected and/or transmitted energy.

FIGURE 3

EP 1 037 060 A2

## Description

This invention relates to the measurement of parameters associated with two ports of devices which utilise electromagnetic energy. It particularly relates to arrangements and methods for measuring insertion loss (transmission coefficient) and return loss (reflection coefficient) in a scalar network analyser system. It more particularly relates to such scalar network analyser systems for use at radio frequencies, in particular, microwave frequencies.

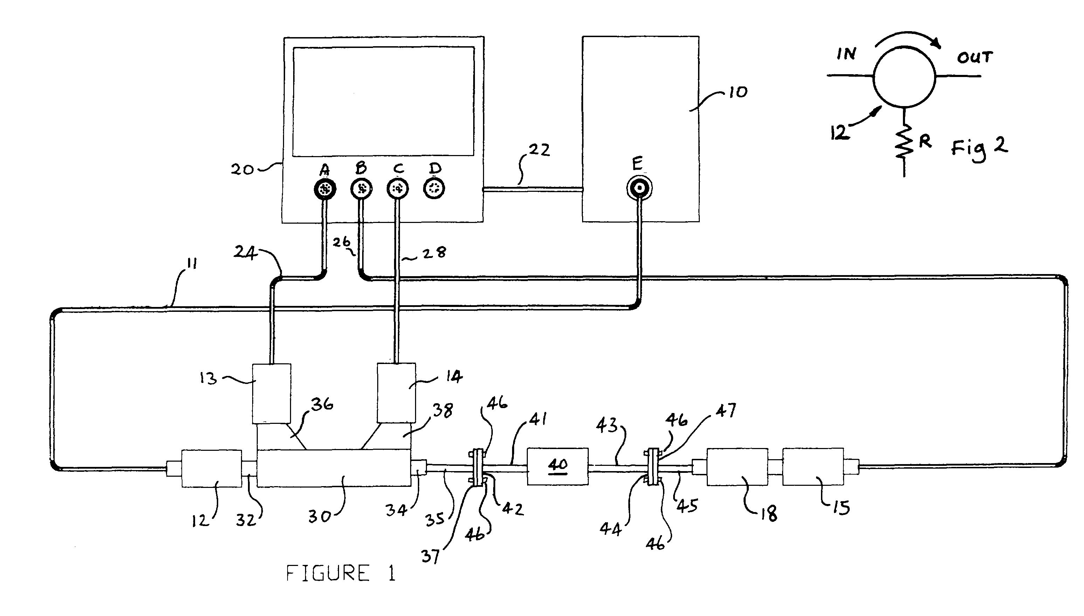

Conventional scalar network analyser systems allow the measurement of Return Loss of one port of multi-port R.F. components and Insertion Loss between two ports. Figure 1 shows a typical measurement system.

RF power from an RF output port E of an RF signal generator 10 is supplied via signal path 11 and an isolator 12 to a first input port 32 of a four-port directional coupler 30.

As is known to those skilled in the art, the isolator 12 ensures a good source match from the RF signal generator 10 by preventing any RF reverse signal reflected back out of the directional coupler input port from reaching the RF generator 10. As shown schematically in fig 2, isolator 12 typically consists of a three-port circulator. A signal applied to a first port IN emerges at a second port OUT, and a signal applied to port OUT is dissipated in a resistive load R coupled to the third port of the circulator. The isolator may be omitted altogether if reverse signal can be tolerated.

A first detector 13 at a first coupled output 36 of the directional coupler 30 is coupled to an input A of a processing unit 20 via cable 24. A second detector 14 at a second coupled output 38 of the directional coupler 30 is coupled to an input C of the processing unit 20 via cable 28. A through output 34 of the directional coupler supplies the RF signal via an output port 37 to a first port 42 of a two-port device under test (DUT) 40. A second port 44 of the DUT is coupled via an input port 47 and a second isolator 18 to a third detector 15 coupled to a third input B of the processing unit 20 via cable 26. The second isolator 18 is of like construction, and performs the corresponding function, as the first isolator 12. RF generator 10 communicates its instantaneous output frequency to processing unit 20 via cable 22 to allow swept frequency measurements to be made in known manner.

In this example of the prior art, the DUT ports consist of waveguides 41, 43 to which connections are made via corresponding sections of waveguide 35, 45. Waveguide flanges 42 and 44 constitute the first and second ports of the DUT. Waveguide flange 37 constitutes the port at which forward reflection coefficient is measured. Waveguide flange 47 constitutes the port at which forward transmission coefficient is measured. Inserting and removing the DUT 40 involves fastening and unfastening of screws 46 by which the mating waveguide flanges are held in engagement.

Detector 14 measures RF power incident on the first port 42 of the DUT, detector 13 measures RF power reflected from the said first port, and detector 15 measures RF power transmitted by the DUT from the first port 42 to the second port 44. Each detector produces an output voltage proportional to the RF power which it is measuring and provides a termination for the port to which it is attached.

The measurement output voltages from the three detectors are processed by processing unit 20 to give an indication of Device Under Test Return Loss at port 42

$$= \frac{\text{REFLECTED POWER}}{\text{INCIDENT POWER}},$$

which is proportional to

$$\frac{\text{VOLTAGE AT DETECTOR 13}}{\text{VOLTAGE AT DETECTOR 14}}$$

and Device Under Test Insertion Loss from first port 42 to second port 44

$$= \frac{\text{TRANSMITTED POWER}}{\text{INCIDENT POWER}},$$

which is proportional to

$$\frac{\text{VOLTAGE AT DETECTOR 15}}{\text{VOLTAGE AT DETECTOR 14}}$$

As the skilled person is well aware, the law of proportionality will depend on the characteristics of the particular type of detector employed, and the measurement system will be calibrated accordingly in known manner.

One disadvantage with the above prior system is that it requires that the Device Under Test to be physically reversed if Return Loss of the second port 44 or the opposite direction Insertion Loss is required to be measured.

This means that the DUT has to be disconnected, physically turned around, and reconnected before making another set of measurements. This is particularly inconvenient for waveguide flange connections which require precise mechanical alignment and the removal and reinsertion of several fastenings for each flange when breaking or making a connection.

The present invention seeks to provide an improved arrangement in which the disadvantages of the prior art are alleviated.

A first aspect of the invention provides a circuit for selectively measuring electromagnetic parameters between first and second ports of a network, the circuit comprising: a source of electromagnetic energy; first and second measurement means, each said means comprising a respective input port and an interface port and respective first and second detector means arranged to detect the level of electromagnetic energy passing from the input port to the interface port and from the interface to the input port respectively; means to couple the detector outputs to a processor means which determines electromagnetic parameters of the network by comparing magnitudes of detector outputs; means to couple said first and second ports to said interface ports; means to alternately couple electromagnetic energy to each said input port in turn whereby the parameters of the network can be determined with respect to both ports in both directions without disconnecting the network from the measurement means.

A second aspect of the invention provides a method of measuring electromagnetic energy parameters of a network between first and second ports comprising the steps of connecting a first measurement means to the first port and a second measurement means to the second port, each measurement means comprising first and second through ports and first and second detector means for respectively measuring the magnitude of power flowing from the first to the second through port and vice versa, coupling the outputs of the detector means to a processing means arranged to determine said parameters from ratios of the detector outputs, coupling the second through ports to the first and second ports of the network, applying a source of electromagnetic energy to the first through port, thereby measuring device parameters looking into the first port, removing the source of electromagnetic energy, and applying a source of electromagnetic energy to the second through port, thereby measuring device parameters looking into the second port.

Embodiments of the invention will now be described by way of non-limiting example only, with reference to the drawings in which

Fig 1 shows a prior art arrangement;

Fig 2 shows a circulator configured as an isolator;

Fig 3 shows a first embodiment of the invention; and

Fig 4 show a second embodiment of the invention.

In the figures the same reference numerals have been used in the embodiments and the prior art to indicate corresponding items.

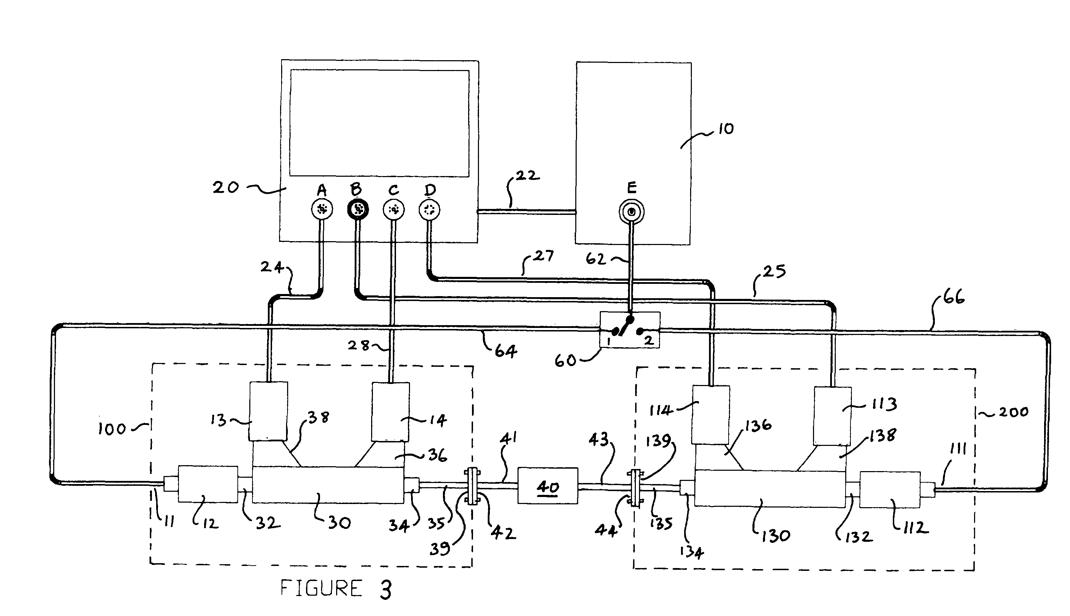

Referring now to figure 3, it will be seen that the circuit is symmetrical. The components within the dashed box 100 and referenced by two digit numbers XX are identical with corresponding components within dashed box 200 and referenced by three digit numbers 1XX. Components 100 constitute a first measurement assembly and components 200 constitute a second measurement assembly.

Circulator 12, directional coupler 30 and detectors 13, 14 are identical with the correspondingly-referenced components previously described with reference to figure 1 and will not be described further. Similarly, circulator 112, directional coupler 130, detectors 113, 114 are identical with the correspondingly-referenced components 12, 30, 13 and 14 and will not be described further.

A device under test DUT is coupled between flanges 39 and 139 which constitute the respective interface ports of the measurement assemblies 100, 200. Flange 39 is connected via waveguide 35 to port 34 of coupler 30 and flange 139 is coupled via waveguide 135 to port 134 of coupler 130. A signal from the RF signal source 10 is fed via cable 62 to a two-way switch 60 which can couple cable 62 either to cable 64 and thence via input port 11 to assembly 100, or else to cable 66 and thence via input port 111 to assembly 200. Output signal from detector 113 is coupled to input port B of analyser 20 via cable 25, and an output signal from detector 114 is coupled to input port D via cable 27.

Operation is as follows.

Considering port 42 to be the input port and port 44 to be the output port of the DUT, let the switch 60 be set to position 1. An RF signal now passes via input 11 and circulator 12 into port 32 of coupler 30 and thence via interface port 39 to the input port 42 of the DUT.

As in the prior art, detector 14 will detect the magnitude of incident RF power, and detector 13 will detect the power reflected back from port 42 of the DUT at interface port 39.

RF signal emerging from port 44 of the DUT 40 enters interface port 139 and passes to port 134 of coupler 130. A proportion of this RF signal emerges at port 138 and is detected by detector 113. Detector 113 generates a voltage proportional to the power of this RF signal, which voltage is fed via cable 25 to port B of processor 20. The remainder of the RF signal passes via port 132 to circulator 112 where it is absorbed. Detector 114 is not used in this measurement phase.

Detector 113 thus measures the amount of power passing through the DUT. As in the first embodiment, the Return Loss at port 42 is proportional to $\frac{V_{13}}{V_{14}}$ and Insertion Loss from 42 to 44 is proportional to $\frac{V_{13}}{V_{14}}$.

To measure Return Loss and Insertion Loss in the opposite direction from 44 to 42, it is only necessary to reverse switch 60. RF power now flows via cable 66, input 111, and isolator 112 through coupler 130 and interface port 139 to port 44 of DUT 40 and thence via interface port 39 to port 34 of coupler 30. Detector 114 measures incident power and provides a signal to port D, detector 113 measures reflected power and provides a signal to port B, detector 13 measures transmitted power and provides a signal to port A. Return Loss at port 44 is proportional to $\frac{V_{13}}{V_{114}}$ and Insertion Loss from port 44 to 42 is proportional to $\frac{V_{13}}{V_{114}}$

The forward and reverse Return Loss and Insertion Loss of the DUT can therefore be measured from both directions without having to physically remove, rotate, and replace the DUT. This is a particular advantage where a number of measurements are made as part of the setting-up or adjustment of a DUT.

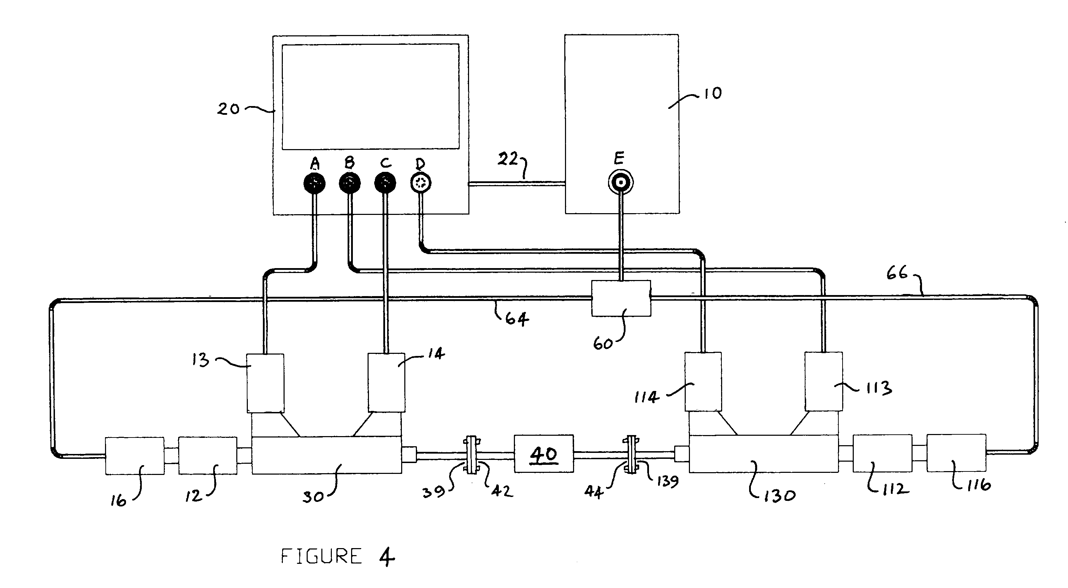

Figure 4 shows a second embodiment which is advantageous where test requires high frequencies or high power levels. This embodiment differs from fig 3 only in that first and second frequency changers 16, 116 are provided between cables 64, 66 and coupler inputs 32, 132. This means that the switch 60 only has to handle a lower frequency than the frequency applied to the DUT 40. It also allows the use of an RF signal generator of lower frequency capability than the frequency used to test the DUT. Operation is otherwise identical with the first embodiment. In the illustrated embodiment the frequency changers consist of frequency multipliers, but other types of frequency changer may be used, such as mixers in conjunction with a local oscillator and appropriate filters.

In a modification of fig 4, not shown, frequency changers 16, 116 include amplifiers. This allows a DUT to be tested at a higher power than is available from the signal source. It also allows the use of a switch 60 having a relatively low power rating. In a further modification not shown, frequency changers 16, 116 of fig 4 are replaced by amplifiers, again allowing the use of a low-power switch 60 for tests at high power.

A number of other modifications are possible according to requirements. Thus at appropriate frequencies some or all of the cables may be replaced by waveguides or other transmission media with transitions as appropriate.

While the embodiments show the use of a switch to selectively couple the signal source to the input ports of the couplers, this is not essential. In modifications of figs 3 and 4, not shown, cables 64, 66 are simply connected and disconnected in turn to output port E of the signal source 10. While this is less convenient than using a switch, only one connection has to be changed, and the DUT does not have to be disturbed. It can be used with advantage where the frequency and/or power level makes the use of a switch impractical.

In a further modification, not shown, two discrete signal sources are employed, one or the other being energised according to the direction of energy flow for which measurements are to be made. This avoids the need to make or break connections at the expense of providing an additional signal source.

While the exemplary embodiments describe the invention as applied to RF frequencies, the invention is also equally appliable to any other fields utilising other forms of electromagnetic energy. Thus in an arrangement for measuring the parameters of an optical component, light sources, fibre optic cables, beamsplitters and light detectors etc are substituted for the signal generators, cables, directional couplers and detectors etc of figs 3 and 4. "Optical" includes infra-red and ultra violet, as well as visible light.

While the embodiments describe measurements made on a two-port device, it will be evident that the invention is equally applicable to measurements made on two selected ports of devices having more than two ports.

## Claims

1. A circuit for selectively measuring electromagnetic parameters between first and second ports (42, 44) of a network (40), the circuit comprising:

   a source (10) of electromagnetic energy;
   first and second measurement means (100, 200), each said means comprising a respective input port (11, 111), an interface port (39, 139), and respective first (14, 114) and second (13, 113) detector means arranged to detect the level of electromagnetic energy passing from the input port (11, 111) to the interface port (39, 139) and from the interface port (39, 139) to the input port (11, 111) respectively;
   means to couple the detector outputs (24, 25, 27, 28) to a processor means (20) which determines electromagnetic parameters of the network by comparing magnitudes of detector outputs;
   means (46) to couple said first and second ports to said interface ports;
   means (60) to alternately couple electromagnetic energy to each said input port in turn whereby the parameters of the network can be determined with respect to both ports in both directions without disconnecting the network from the measurement means.

2. A circuit as claimed in claim 1 in which the means to alternately couple comprises a change-over switch (60).

3. A circuit as claimed in claim 1 or 2 in which each said measurement means (100, 200) comprises a respective directional coupler means (30, 130), the first (14, 114) and second (13, 113) detector means being coupled to respective forward (36, 136) and reverse (38, 138) coupled ports of the coupler means.

4. A circuit as claimed in claim 3 in which each measurement means further comprises isolator means (12, 112) having an input port for receiving electromagnetic energy and an output port connected to the input port (32, 132) of the coupler (30, 130) and arranged to allow passage of electromagnetic energy from the input (11, 111) of the isolator into the input port (32, 132) of the coupler and to absorb electromagnetic energy emerging from the input port into the isolator means.

5. Apparatus as claimed in claim 3 or 4, in which each measurement means comprises a respective frequency changer means (16, 116) arranged in the signal path between the source of electromagnetic energy (10) and the input port (32, 132) of the coupler.

6. Apparatus as claimed in any one of claims 3 to 5 in which each measurement means further comprises amplifier means in the signal path between the source of electromagnetic energy and the coupler.

7. Apparatus as claimed in any preceding claim in which the electromagnetic energy comprises radio frequency energy.

8. Apparatus as claimed in any preceding claim in which the electromagnetic parameters comprise the reflection coefficient of energy incident at a network port and the transmission coefficient of energy from one network port to the other network port.

9. A method of measuring electromagnetic energy parameters of a network (40) between first and second ports (42, 44) thereof comprising the steps of

connecting a first measurement means (100) to the first port (42) and a second measurement means (200) to the second port (44), each measurement means comprising first (32, 132) and second (39, 139) through ports and first (14, 114) and second (13, 113) detector means for respectively measuring the magnitude of power flowing from the first to the second through port and vice versa,
coupling the outputs of the detector means (13, 14, 113, 114) to a processing means (20) arranged to determine said parameters from ratios of the detector outputs,
coupling the second through ports (39, 139) to the first and second ports (42, 44) of the network,
applying a source of electromagnetic energy (10) to the first through port (42), thereby measuring device parameters looking into the first port,
removing the source of electromagnetic energy, and
applying a source of electromagnetic energy to the second through port (44), thereby measuring device parameters looking into the second port.

10. A method as claimed in claim 9 in which the electromagnetic energy comprises radio frequency energy.

FIGURE 1

Fig 2

FIGURE 3

7

FIGURE 4